# EUROPEAN PATENT APPLICATION

(11) **EP 4 451 340 A1**
(43) Date of publication of application: **23.10.2024**
(21) Application number: 23216353.5
(22) Date of filing: 13.12.2023
(51) Int. Cl.: H01L 29/423, H01L 29/66, H01L 29/06, H01L 21/02

(54) **NANORIBBON-BASED TRANSISTOR WITH UNIFORM OXIDE**

(30) Priority: 20.04.2023 US 202318303932
(71) Applicant: Intel Corporation, Santa Clara, CA 95054 (US)
(72) Inventor: GUPTA, Siddharth, Hillsboro 97124 (US); CHAO, Robin, Portland 97209 (US); GUPTA, Jay Prakash, Hillsboro 97124 (US); KILLAMPALLI, Aravind, Portland 97229 (US); GUHA, Biswajeet, Hillsboro 97124 (US)
(74) Representative: 2SPL Patentanwälte PartG mbB

(57) **Abstract**

Described herein are nanoribbon-based transistors with a highly uniform oxide layer around semiconductor nanoribbon channels, and a high-pressure steam process for growth the oxide layer. The high-pressure steam process is a self-limiting process that results in a more uniform oxide than standard deposition or implantation methods. The uniformity enables greater control over oxide thickness, with improved breakdown voltages and drive currents.

## Description

### Technical Field

This disclosure relates generally to the field of integrated circuit (IC) structures and devices, and more specifically, to nanoribbon-based transistors with uniform oxides, and a high-pressure steam process for producing a uniform oxide layer around stacks of nanoribbons.

### Background

Gate all around (GAA) transistors, also referred to as surrounding-gate transistors, have a gate material that surrounds a channel region on all sides. GAA transistors may be nanoribbon-based or nanowire-based, and they can also be referred to as nanoribbon transistors or a nanowire transistors. In a nanoribbon transistor, a gate stack that may include one or more gate electrode materials and a gate dielectric may be provided around a portion of an elongated semiconductor structure called "nanoribbon", forming the gate stack on all sides of the nanoribbon. A source region and a drain region can be provided on the opposite ends of the nanoribbon, on either side of the gate stack, forming, respectively, a source and a drain of such a transistor. Other transistors based on non-planar architecture include fin-shaped transistor devices, also referred to as FinFETs.

In some nanoribbon device fabrication processes, semiconductor nanoribbons are released from a surrounding supportive material, and the gate stack is regrown around the semiconductor nanoribbons to form a gate. The gate stack includes one or more dielectric layers, surrounded by a conductive gate electrode. Typically, an oxide growth process for forming the gate dielectric is tuned to a particular aspect ratio, e.g., a particular size of nanoribbon or nanowire. Even with process tuning, it can be difficult to control the oxide growth rate, e.g., to achieve uniformity in thickness across multiple nanoribbons at different heights in a transistor.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a cross-section across a nanoribbon-based transistor showing the source, gate, and drain, according to some embodiments of the present disclosure.
FIG. 1B is a cross-section of the nanoribbon-based transistor through the plane AA' in FIG. 1A, according to some embodiments of the present disclosure.
FIG. 2 is a flow diagram of a process for fabricating a nanoribbon-based transistor, according to some embodiments of the present disclosure.
FIG. 3 is a cross-section of layers of alternating materials, according to some embodiments of the present disclosure.
FIG. 4A is a cross-section across a pair of adjacent nanoribbons, according to some embodiments of the present disclosure.
FIG. 4B is a cross-section of two stacks of unreleased nanoribbons through the plane CC' of FIG. 4A, according to some embodiments of the present disclosure.
FIG. 5 is a cross-section illustrating the release of nanoribbons from the stacks of alternating materials, according to some embodiments of the present disclosure.
FIG. 6 is a cross-section illustrating growth of a uniform oxide layer around the nanoribbons, according to some embodiments of the present disclosure.
FIG. 7 is a zoomed-in version of one stack of nanoribbons illustrating dimensions of the oxide layer, according to some embodiments of the present disclosure.
FIG. 8 is a cross-section illustrating a high-k dielectric deposited over the oxide layer, according to some embodiments of the present disclosure.
FIGS. 9A and 9B are top views of a wafer and dies that include one or more nanoribbon transistors with uniform oxide layers which may be formed under a high-pressure steam process in accordance with any of the embodiments disclosed herein.
FIG. 10 is a cross-sectional side view of an IC device that may include one or more nanoribbon transistors with uniform oxide layers which may be formed under a high-pressure steam process in accordance with any of the embodiments disclosed herein.
FIG. 11 is a cross-sectional side view of an IC device assembly that may include one or more nanoribbon transistors with uniform oxide layers which may be formed under a high-pressure steam process in accordance with any of the embodiments disclosed herein.
FIG. 12 is a block diagram of an example computing device that may one or more nanoribbon transistors with uniform oxide layers which may be formed under a high-pressure steam process in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are IC devices that include nanoribbon-based transistors having uniform oxide layers across multiple nanoribbons at different heights. The uniform oxide layer may be formed under a high-pressure steam process.

Nanoribbon-based transistors provide several advantages over other transistor architectures. For example, nanoribbon transistors provide improved electrostatic transistor control and faster transistor speeds relative to other transistor architectures. In addition, nanoribbon-based channels provide increased drive current at smaller scales relative to other nonplanar architectures, such as fin-shaped channels.

Transistors typically include a gate stack coupled to a semiconductor channel, such as a nanoribbon or a stack of nanoribbons. A gate stack includes a gate electrode and a gate dielectric, with the gate dielectric formed between the gate electrode and the channel material. In a nanoribbon transistor, the gate dielectric is formed around each nanoribbon, and the gate electrode is formed over and around the gate dielectric, including in spaces between adjacent nanoribbons in the stack. The gate dielectric may include an oxide. For example, if the nanoribbon channels are formed from silicon, the gate dielectric may include a layer of silicon oxide. A second dielectric layer, which may be a high-k dielectric, may be formed over the silicon oxide.

Current fabrication techniques for nanoribbon-based transistors include direct oxidization of the nanoribbon channels at high heats, e.g., heats above 600° Celsius (C) or above 700° C. For example, a non-equilibrium plasma implantation of oxygen may be used to grow the oxide layer. Due to the non-equilibrium nature, oxide growth beyond thermal oxidation may occur. This can lead to lack of uniformity of the oxide layer. For example, there is an inherent directional dependence of growth rates throughout the plasma implantation process. In a resulting transistor device, the lower-most nanoribbon of the transistor typically has the thinnest oxide.

Non-uniformity of the oxide layer impacts the breakdown voltage and drive current of the device. Breakdown voltage is controlled by the thinnest portion of oxide, while drive current scales with thicker oxide layers. It is advantageous to have both a high breakdown voltage and a high drive current. However, due to the non-uniform nature of existing oxide processes, the overall amount of deposited oxide is made greater to preclude a low breakdown voltage, thus lowering the drive current. Conversely, to obtain a higher drive current, the breakdown voltage may be lower than desired.

Current processes for oxide growth on nanoribbon channels have other drawbacks. For example, the plasma implantation process depends on the ribbon's geometry, e.g., the width and height of the nanoribbons. In addition, the non-uniformity effect changes based on the number of nanoribbons in a transistor device. Thus, when a new design is introduced, a new plasma implantation process needs to be built.

Furthermore, to create complex transistor architectures such as GAA transistors, complex patterning schemes are used in building a gate stack. Complex patterning is typically achieved using a carbon hard mask; however, the relatively low processing temperatures required by a carbon hard mask conflict with the relatively high heat required by existing oxide growth processes. In some cases, the upper temperature limit for the carbon hard mask may be reached before a desired oxide thickness is achieved.

As described herein, a high-pressure steam process is used to obtain uniform oxide growth on nanoribbon or nanowire channels at relatively low temperatures. The high-pressure steam process may produce self-limiting oxidization of silicon nanoribbons, resulting in a uniform silicon oxide around the nanoribbons. For example, the thickness of the oxide layer across a transistor may be within a relatively small range, e.g., a thinnest point or region of the oxide layer may be within 1% or 2% of a thickest point or region of the oxide layer.

The uniform oxide provided by the high-pressure steam process provides superior breakdown voltage and drive current compared to previous oxide grown through previous processes. In particular, having a target uniform thickness across the nanoribbon transistor, rather than an oxide layer with portions that are thicker than the target thickness, increases the drive current voltage compared to prior devices. In addition, the uniform thickness prevents an unintended thinner section from decreasing the breakdown voltage of the device. The steam process is also easily adapted to different device geometries, e.g., nanoribbons with different aspect ratios, or transistors with more or fewer nanoribbons.

As a further advantage, the high-pressure steam process does not introduce other chemicals into the process, such as catalysts or other chemicals that may lead to defects in the oxide layer. Thus, the high-pressure steam process increases device reliability compared to previous processes.

The nanoribbon transistors described herein may be implemented in one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

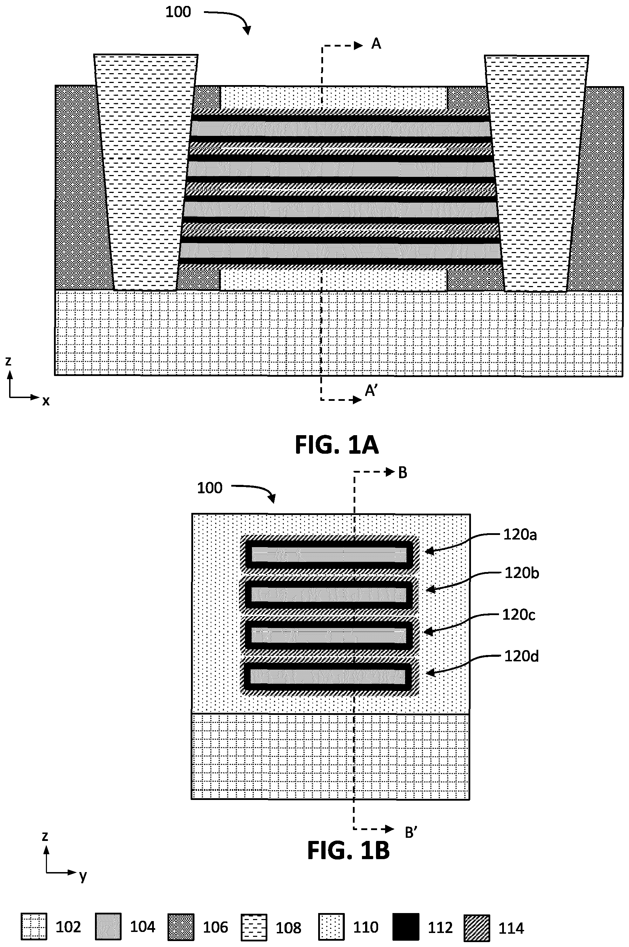

For convenience, if a collection of drawings designated with different letters are present, e.g., FIGS. 1A-1B, such a collection may be referred to herein without the letters, e.g., as "FIG. 1."

### Example nanoribbon transistors with uniform oxide layer

FIGs. 1A-1B illustrate a nanoribbon-based transistor with a uniform oxide layer around the nanoribbon channels. FIG. 1A is a cross-section across a transistor 100 showing the source, gate, and drain. FIG. 1B is a cross-section across the gate regions of the transistor 100. FIG. 1B is a cross-section through the plane AA' in FIG. 1A, and FIG. 1A is a cross-section through the plane BB' in FIG. 1B.

A number of elements referred to in the description of FIGs. 1A, 1B, and 3-8 with reference numerals are illustrated in these figures with different patterns, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) contact 108, a gate electrode 110, an oxide 112, and a high-k dielectric 114.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

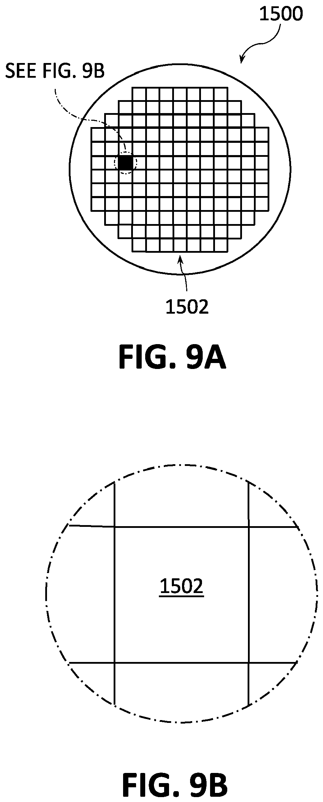

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 1500 of FIG. 9A, discussed below, and may be, or be included in, a die, e.g., the singulated die 1502 of FIG. 9B, discussed below. The support structure 102 extends along the x-y plane in the coordinate system shown in FIG. 1.

In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

In FIGs. 1A and 1B, a transistor 100 is formed over a support structure 102. The transistor 100 includes a channel material 104 formed into four nanoribbons stacked on top of each other. The channel material 104 may be a semiconductor, such as silicon or other semiconductor materials described herein.

The transistor 100 includes nanoribbons 120a, 120b, 120c, and 120d, referred to collectively as nanoribbons 120 or individually as a nanoribbon 120. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the shortest distance from the support structure 102. S/D contacts 108 are formed around either end of the nanoribbon channels 120, as illustrated in FIG. 1A.

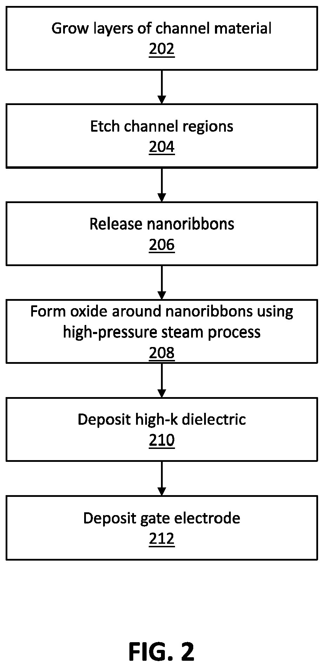

A central portion of each of the nanoribbon channels 120 is surrounded by a gate electrode 110. A gate dielectric surrounds the nanoribbon channels 120 under the gate electrodes 110. In this example, the gate dielectric around each nanoribbon channel 120 includes a layer of an oxide 112 and a layer of a high-k dielectric 114. The oxide 112 is grown directly on the nanoribbon channels 120, and the high-k dielectric 114 surrounds the oxide 112. Regions of the nanoribbon channels 120 not surrounded by the oxide 112, high-k dielectric 114, and gate electrode 110, or by an S/D contact 108, are filled in with a dielectric material 106. As described in detail with respect to FIG. 2, the oxide 112 may be grown on the nanoribbon channels 120 using a high-pressure steam process.

The oxide 112 is of substantially uniform thickness across the transistor 100. For example, across the transistor 100, the thickness of the oxide 112 may be within 1% of a target thickness, within 2% of a target thickness, within 3% of a target thickness, or within some other range. The oxide 112 is substantially uniform across each individual nanoribbon 120, e.g., in a given cross-section of a nanoribbon 120, the minimum thickness of the oxide 112 may be within 1%, within 2%, within 3%, or within 5% of a maximum thickness of the oxide 112. The uniformity may me observed around the nanoribbon on all sides, e.g., the same thickness, or substantially same thickness, may be observed along the top, bottom, and sides of the nanoribbon 120. The cross-section illustrating the substantial uniformity may be lengthwise through the nanoribbon 120 (e.g., as shown in FIG. 1A), or across a gate portion of the nanoribbon 120 (e.g., as shown in FIG. 1B). The uniformity may be observed across the full nanoribbon 120, e.g., across multiple cross-sections at different positions (e.g., different locations in the x-direction or the y-direction).

Furthermore, the oxide 112 is substantially uniform across different nanoribbons 120. For example, in a given cross-section of the transistor 100, whether the cross-section may be similar to the cross-section in FIG. 1A or 1B, a first thickness (e.g., a maximum thickness, a minimum thickness, an average thickness (e.g., an average across a selection of multiple points in the cross-section), a median thickness (e.g., a median thickness across a selection of multiple points in the cross-section), a thickness at any randomly selected point, or any other selected thickness measurement) of the layer of oxide 112 around a first nanoribbon (e.g., nanoribbon 120a) may be within 1%, 2%, 3%, or 5% of a second thickness (e.g., a maximum thickness, a minimum thickness, an average thickness, a median thickness, a thickness at a randomly selected point, or any other selected thickness measurement) of the layer of oxide 112 around a second nanoribbon (e.g., nanoribbon 120d).

In certain embodiments, the transistor 100 may achieve particular device characteristics at a given oxide thickness not achievable using prior processing techniques. For example, a relatively low oxide thickness may be achieved, e.g., less than 30 angstroms (Å) or less than 40 Å. In addition, a relatively high breakdown voltage may be achieved at these oxide scales, e.g., at least 4 volts (V) or at least 4.5 V. For an oxide thickness in a range of 15 to 35 Å, the transistor 100 may have a breakdown voltage in the range of 4 to 5 V. This transistor 100 may have a drive current of at least 20 microamps (µA), at least 40 µA, or at least 60 µA. In some embodiments, the drive current is within a certain range, e.g., 20-40 µA, 40-60 µA, or 60-80 µA. In some embodiments, the oxide thickness may be lower (e.g., 5 to 20 Å), and the transistor may have a correspondingly lower breakdown voltage (e.g., 3 to 4 V) and/or lower drive current (e.g., at least 10 µA).

### Example process for forming nanoribbon device with uniform oxide layer

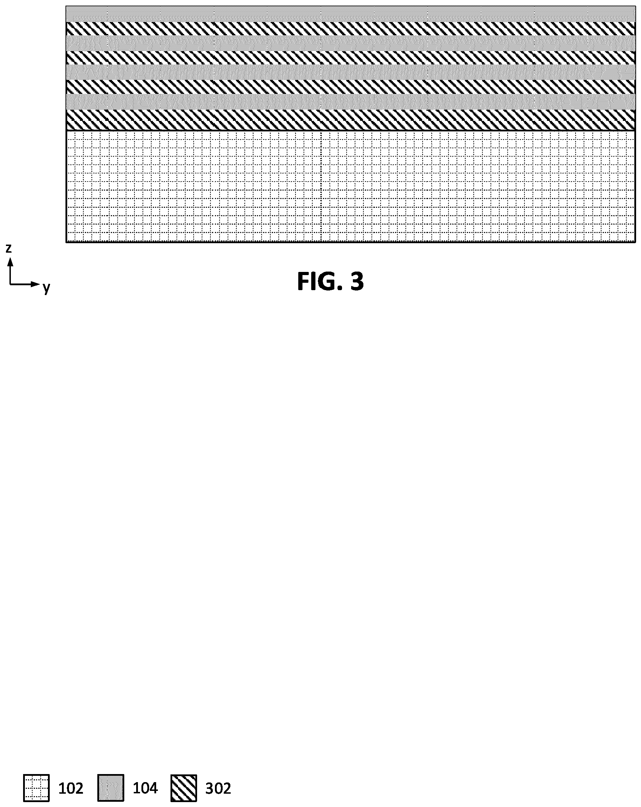

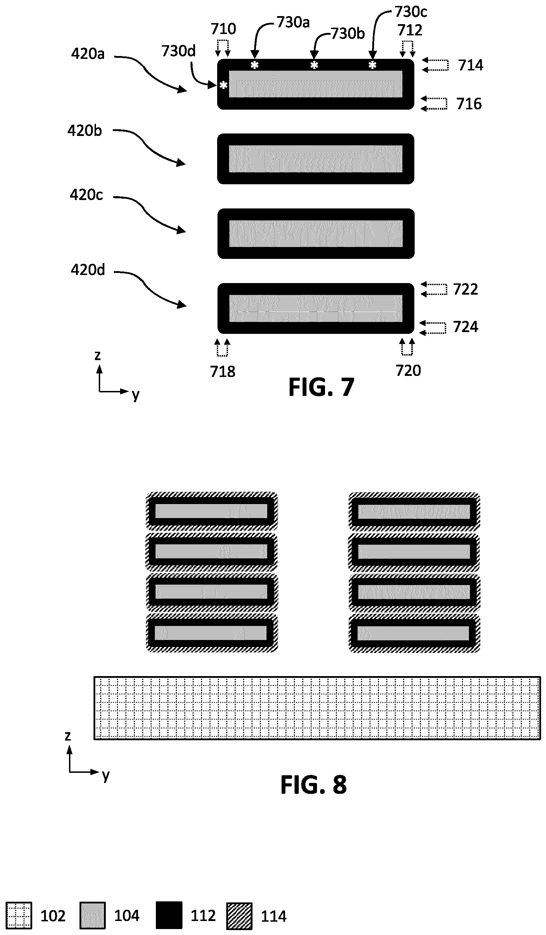

FIG. 2 is a flowchart illustrating an example processing method for forming the transistor device shown in FIG. 1, according to some embodiments of the present disclosure. FIGs. 3-8 illustrate various steps in the processing method of FIG. 2, according to some embodiments of the present disclosure. In general, the processing method shown in FIG. 2 is performed across a wafer, with many individual transistors formed on the wafer. FIGs. 3-6 and FIG. 8 illustrate cross-sections of processing steps for two example transistors on the wafer; FIG. 7 shows an enlarged view of a cross-section of a single transistor.

At 202, a process for growing layers of channel material over a support structure is performed. FIG. 3 is a cross-section illustrating layers of alternating materials 104 and 302 formed over a support structure 102, e.g., a substrate as described with respect to FIG. 1. The alternating materials 104 includes layers of the channel material 104 separated by layers of a sacrificial material 302. In general, to form nanoribbon channels, alternating layers of the channel material 104 and the sacrificial material 302 are deposited over the support structure 102. The channel material 104 and sacrificial materials 302 include different materials. In one example, the channel material 104 is silicon, while the sacrificial material 302 is a mixture of silicon and germanium. The sacrificial material 302 may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material 302 (or substantially monocrystalline layers) may be formed over each other. In different embodiments, the channel material 104 and/or the sacrificial material 302 may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both n-type metal-oxide-semiconductor (NMOS) transistors and p-type MOS (PMOS) transistors, e.g., alternating rows of NMOS and PMOS transistors. NMOS and PMOS logic can use different groups of channel material 104, e.g., silicon may be used to form an n-type semiconductor channel, while silicon germanium may be used as to form a p-type semiconductor channel. In some embodiments, a single channel material 104 is used (e.g., silicon), and different portions (e.g., channel material to form different transistors) may include different dopants, e.g., n-type dopants for NMOS transistors and p-type dopants for PMOS transistors.

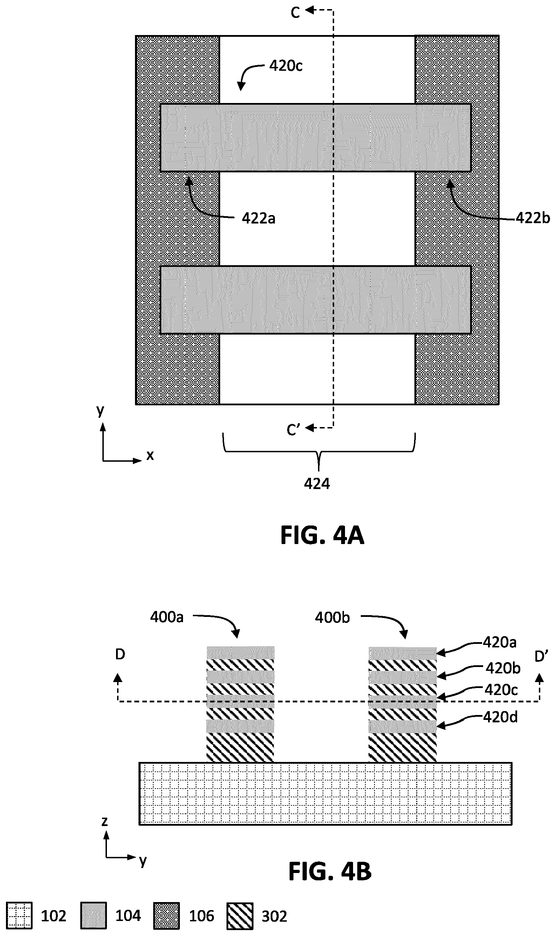

Returning to FIG. 2, at 204, a process to etch channel regions in the layers of alternating materials 104 and 302 is performed. FIGs. 4A and 4B illustrate the nanoribbon channel material 104 after stacks have been etched to form individuated channel regions. For example, rows may be patterned using photolithography, and portions of the alternating layers are removed, leaving the stacks 400a and 400b illustrated in FIG. 4B.

In the example shown in FIG. 4B, the channel material 104 is formed into four nanoribbons stacked on top of each other. For example, the stack 400b includes nanoribbons 420a, 420b, 420c, and 420d. Each nanoribbon 420 is at a different height in the z-direction in the orientation shown in FIG. 4B, i.e., a different distance from the support structure 102. The stacks 400a and 400b each have four nanoribbons. In other embodiments, the stacks 400a and 400b, and transistors formed from the nanoribbon stacks, may each have fewer nanoribbons (e.g., one, two, or three nanoribbons), or more than four nanoribbons (e.g., five nanoribbons, six nanoribbons, etc.). The sacrificial material 302 is below the lowest nanoribbon 420d (i.e., between the support structure 102 and the nanoribbon 420d) and between adjacent nanoribbons (e.g., between nanoribbon 420d and 420c, between nanoribbon 420c and 420b, etc.).

The nanoribbons 420 each have an elongated structure that extends over the support structure 102. Each nanoribbon 420 extends primarily in the x-direction in the coordinate system used in FIGs. 3-8. The direction in which the nanoribbons 420 extend is parallel to the support structure 102.

As illustrated in FIG. 4A, a dielectric material 106 is formed at either end of the nanoribbon channels, e.g., the ends 422a and 422b of the nanoribbon 420c. The dielectric material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials 106 include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

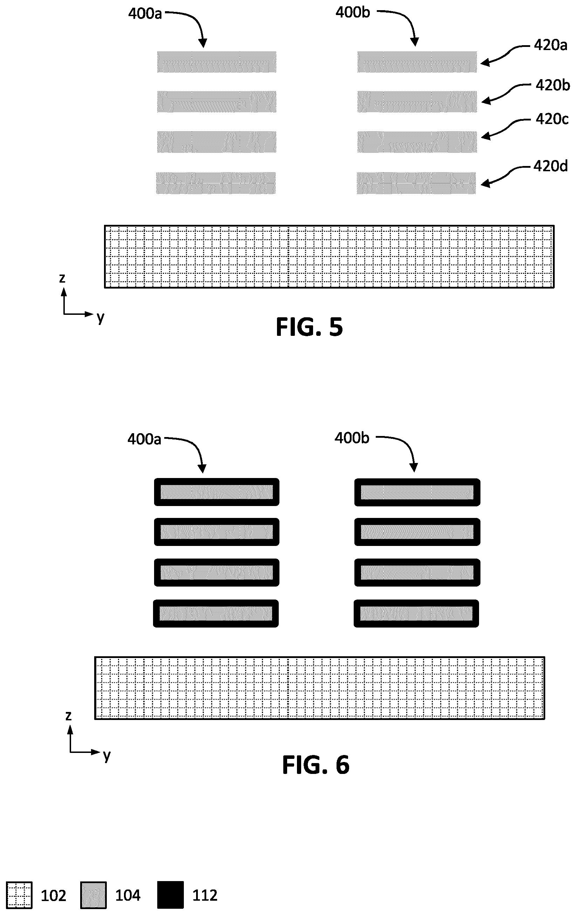

At the stage illustrated in FIG. 4, the layers of channel material 104 are supported by the alternating layers of sacrificial material 302. As illustrated in FIG. 5 and discussed below, the sacrificial material 302 is removed, leaving the nanoribbons 420 "floating." After the sacrificial material 302 is removed, the nanoribbons 420 are supported on either end and held in their respective positions by the dielectric material 106.

As illustrated in FIG. 1A, in a finished transistor, a S/D contact is formed around the ends of the nanoribbon channels, e.g., around the ends 422a and 422b. The S/D contacts (not illustrated in FIG. 4) may replace a portion of the dielectric material 106. The S/D contacts may be fabricated at any point of the transistor fabrication process. A region between the dielectric material 106, labelled 424 in FIG. 4A, is a gate region of the transistor. A gate stack is formed in some or all of the region 424, as illustrated in FIG. 1. The cross-section in FIG. 4B illustrates is a cross-section through the gate region, i.e., a region of the nanoribbons 420 around which the gate stack is formed.

Returning to FIG. 2, at 206, a process to release the nanoribbons 420 is performed. FIG. 5 is a cross-section illustrating the release of nanoribbons from the stacks of alternating materials, according to some embodiments of the present disclosure. In FIG. 5, the sacrificial material 302 has been etched, leaving the nanoribbons 420 floating between the ends in the dielectric material 106, as described above. The sacrificial material 302 may be removed using an etching process, such as dry etch, wet etch, or a combination. An etchant material used to remove the sacrificial material 302 is selective to the channel material 104, i.e., the etchant removes the sacrificial material 302 but does not remove the channel material 104. This process of removing the sacrificial material 302 is referred to as nanoribbon release.

Returning to FIG. 2, at 208, a process to form an oxide around the nanoribbons is performed. The process may be a high-pressure steam process that results in a uniform oxide around the nanoribbons 420. To perform the high-pressure steam process, the support structure 102 having released nanoribbons formed thereon (e.g., a wafer including the released nanoribbons illustrated in FIG. 5) is loaded into a reactor enclosure. The reactor enclosure may be a pressure chamber, which is a chamber designed to generate and withstand a high internal pressure, e.g., a pressure higher than atmospheric pressure. The wafer, or a set of multiple wafers for simultaneous processing, may be loaded on a supporting structure (e.g., a quartz boat or quartz cassette) designed to hold the wafers in the reactor. The reactor may further include an internal vessel (e.g., a quartz vessel) surrounding the supporting structure, and a heating element around the internal vessel. The reactor may have a heating system that includes a mechanism for producing heat (e.g., a boiler) and one or more conductive elements for spreading heat from the heat-producing mechanism throughout the reactor, e.g., to spread heat evenly throughout the reactor's interior.

After the support structure with released nanoribbons is loaded into the reactor, a liquid (e.g., water) may be introduced into the chamber and heated into a gaseous form, producing water vapor or steam. The introduction of water vapor inside the chamber increases the internal pressure in the chamber to produce a high-pressure environment. For example, during a ramp-up steam generation period, the internal temperature may be raised to a process temperature of, e.g., between 300°C and 550°C. In some embodiments, the process temperature may be less 700°C, less than 600°C, or less than 500°C, e.g., between 400°C and 500°C. The internal pressure may be raised to a process pressure, e.g., a pressure over 0.1 megapascals (MPa) or over 1 MPa, e.g., between 1 MPa and 2 MPa, or between 1.5 MPa and 3 MPa. The process temperature and/or process pressure may be selected to obtain a desired oxide thickness. For example, a higher process temperature may generally result in a thicker oxide layer than a lower process temperature.

After the process temperature and process pressure have been reached in the chamber, the wafer processing, i.e., the oxide growth, may be performed. During the wafer processing stage, oxygen (Oz) is introduced to into the chamber. A ratio between oxygen and water vapor in the chamber during the wafer processing may be between, e.g., 5% O₂: 95% H₂O and 35% O₂: 65% H₂O. The oxygen reacts with the exposed portions of the channel material 104 (e.g., silicon), forming an oxide layer around the channel material 104.

As noted above, previous oxide growth methods were non-equilibrium processes, meaning that the growth methods do not have an inherent stopping point, and the oxide layer may continue to grow past a target thickness. This leads to non-uniform growth, and in particular, certain oxide portions that are thicker than others. By contrast, oxide growth for the high-pressure steam process is self-limiting, meaning that after the target thickness is achieved, oxide growth stops or slows significantly. In particular, to create the oxide 112, a portion of the channel material 104 (e.g., silicon) at a surface of the nanoribbons 420 is consumed. The grown oxide 112 (e.g., silicon dioxide) then covers the channel material 104 (e.g., silicon), and the oxygen-rich water vapor cannot reach the channel material 104 below the oxide 112 to grow additional oxide.

After the wafer processing stage, during which the oxide is grown, a depressurization process is performed. During the depressurization process, the internal pressure and temperature of the chamber are lowered, e.g., by releasing steam through one or more outlets, and turning off or turning down the heating element. Following the depressurization process, the wafer may be removed from the pressure chamber for further processing, e.g., for deposition of the high-k dielectric 114.

FIG. 6 is a cross-section illustrating growth of a uniform oxide layer around the nanoribbons, according to some embodiments of the present disclosure. FIG. 6 illustrates the oxide 112 grown over each of the nanoribbons 420.

FIG. 7 is a zoomed-in version of one stack of nanoribbons 420a-420d illustrating dimensions of the oxide layer, according to some embodiments of the present disclosure. In this example, thicknesses of the oxide 112 on the nanoribbons 420a and 420d are illustrated. The thickness 710 is a thickness on one side of the nanoribbon 420a (i.e., on one surface perpendicular to the support structure 102), the thickness 712 is a thickness on the opposite side of the nanoribbon 420a (i.e., on a second surface perpendicular to the support structure 102), the thickness 714 is a thickness on the top of the nanoribbon 420a (i.e., on a surface parallel to and farthest from the support structure 102), and the thickness 716 is a thickness on the bottom of the nanoribbon 420a (i.e., on a surface parallel to and nearest to the support structure 102). The thickness 718 is a thickness on one side of the nanoribbon 420d (i.e., on one surface perpendicular to the support structure 102), the thickness 720 is a thickness on the opposite side of the nanoribbon 420d (i.e., on a second surface perpendicular to the support structure 102), the thickness 722 is a thickness on the top of the nanoribbon 420d (i.e., on a surface parallel to and farthest from the support structure 102), and the thickness 724 is a thickness on the bottom of the nanoribbon 420d (i.e., on a surface parallel to and nearest to the support structure 102). Each of the thicknesses 710-724 is substantially the same, e.g., within 1% or 2% of each other, or of a target value.

The thicknesses 710-724 may be determined in various ways. For example, for a given surface, a thickness may be measured at one or more points within the surface in a TEM or SEM image of a cross-section of the surface. As one example, to determine the thickness 714, a TEM image of the illustrated cross section may be obtained, and thickness measurements at points 730a, 730b, and 730c may be obtained. The thickness measurements at points 730a, 730b, and 730c may all be within a certain range of each other, e.g., within 1%, 2%, or 3%, indicating that the oxide 112 across the top surface of the nanoribbon 420a is substantially uniform. The thickness 714 may encompass the range of the three thickness measurements at the points 730a-730c, one of the thickness measurements (e.g., a minimum, maximum, or median), or an average thickness, for example.

As another example, a thickness measurement at the point 730d may represent the thickness 710. The thickness 710 measured at the point 730d may be within 1%, 2%, or 3% of the thickness 714, determined by the measurements at points 730a-730c, as described above. This may indicate that the oxide 112 around the nanoribbon 420a is substantially uniform. As an example, if the thickness 710 is 20 Å, and the thickness 714 is 20.1 Å, the percentage difference between these thicknesses may be calculated (20.1 - 20) / 20 = 0.005, or 0.5%, which is less than 1%. An overall thickness for the nanoribbon 420a may be determined using the measurements at the points 730a-730d (e.g., a minimum, maximum, median, or average) or a thickness range for the nanoribbon 420a may be determined.

Similar measurements at various points around the nanoribbon 420d may be used to determine the thicknesses 718-724 and compare any or all of the thicknesses 718-724 to any or all of the thicknesses 710-716. Similar measurements may also be obtained for the other nanoribbons 420b and 420c.

Returning to FIG. 2, at 210, a process to deposit a high-k dielectric 114 is performed. The high-k dielectric 114 may be deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces. In some embodiments, an annealing process may be carried out on the high-k dielectric 114 to improve its quality.

FIG. 8 is a cross-section illustrating a high-k dielectric 114 deposited over the oxide layer, according to some embodiments of the present disclosure. The high-k dielectric 114 may include elements such as hafnium, silicon, oxygen, titanium, tantalum, lanthanum, aluminum, zirconium, barium, strontium, yttrium, lead, scandium, niobium, and zinc. Examples of high-k materials that may be used in the high-k dielectric 114 include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

Returning to FIG. 2, at 212, a process to deposit a gate electrode 110 is performed. The gate electrode 110 may be deposited using a conformal deposition process, as described above, or a non-conformal deposition process, such as a physical deposition process. FIG. 1 illustrates an example device after the gate electrode 110 has been deposited.

The gate electrode 110 may be a conductive material, such as a metal. The gate electrode 110 may include at least one P-type work function metal or N-type work function metal. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

### Example devices

The circuit devices with nanoribbon transistors with uniform oxide layers disclosed herein may be included in any suitable electronic device. FIGS. 9-12 illustrate various examples of apparatuses that may include the one or more nanoribbon transistors disclosed herein, which may have been fabricated using the processes disclosed herein.

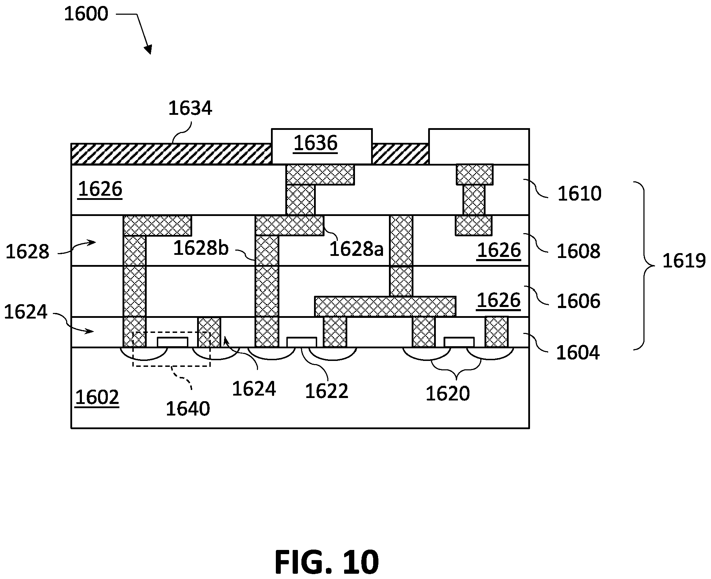

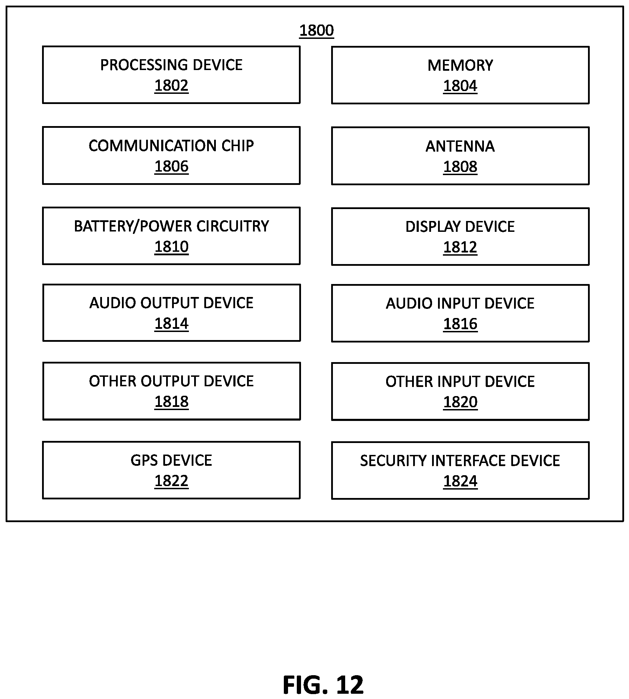

FIG. 9A and 9B are top views of a wafer and dies that include one or more IC structures including one or more nanoribbon transistors with uniform oxide layers which may be formed under a high-pressure steam process in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 2-14, or any further embodiments of the IC structures described herein). After the fabrication of the semiconductor product is complete (e.g., after manufacture of one or more IC structures with one or more of the nanoribbon transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the nanoribbon transistors as disclosed herein may take the form of the wafer 1500 (e.g., not singulated) or the form of the die 1502 (e.g., singulated). The die 1502 may include one or more transistors (e.g., one or more of the transistors 1640 of FIG. 10, discussed below) and/or supporting circuitry to route electrical signals to the transistors, as well as any other IC components (e.g., one or more nanoribbon transistors). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 12) or other logic that is configured to store information in the memory devices or execute instructions stored in the memory array.

FIG. 10 is a cross-sectional side view of an IC device 1600 that may include one or more nanoribbon transistors with uniform oxide layers which may be formed under a high-pressure steam process in accordance with any of the embodiments disclosed herein. The IC device 1600 may be formed on a substrate 1602 (e.g., the wafer 1500 of FIG. 9A) and may be included in a die (e.g., the die 1502 of FIG. 9B). The substrate 1602 may be any substrate as described herein. The substrate 1602 may be part of a singulated die (e.g., the dies 1502 of FIG. 9B) or a wafer (e.g., the wafer 1500 of FIG. 9A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 10 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more nanoribbon transistors with uniform oxide layers at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 10 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 10). Although a particular number of interconnect layers 1606-1610 is depicted in FIG. 10, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 10. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 10. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

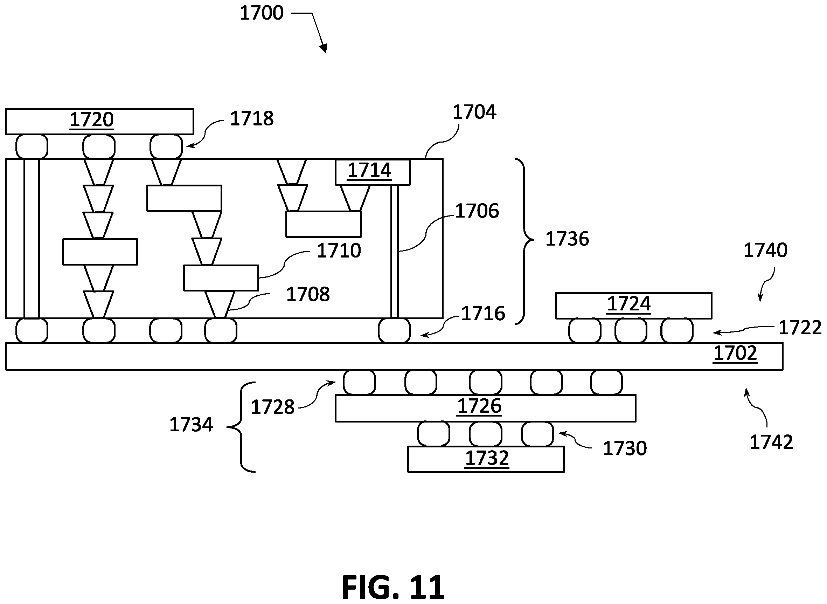

FIG. 11 is a cross-sectional side view of an IC device assembly 1700 that may include components having or being associated with (e.g., being electrically connected by means of) one or more nanoribbon transistors with uniform oxide layers which may be formed under a high-pressure steam process in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the nanoribbon transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 11 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 11), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 11, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 9B), an IC device (e.g., the IC device 1600 of FIG. 10), or any other suitable component. In some embodiments, the IC package 1720 may include one or more nanoribbon transistors with uniform oxide layers, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 11, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 11 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 12 is a block diagram of an example computing device 1800 that may include one or more components including one or more nanoribbon transistors with uniform oxide layers which may be formed under a high-pressure steam process in accordance with any of the embodiments disclosed herein. For example, any suitable ones of the components of the computing device 1800 may include a die (e.g., the die 1502 of FIG. 9B) having one or more nanoribbon transistors as described herein. Any one or more of the components of the computing device 1800 may include, or be included in, an IC device 1600 (FIG. 10). Any one or more of the components of the computing device 1800 may include, or be included in, an IC device assembly 1700 (FIG. 11).

A number of components are illustrated in FIG. 12 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 11, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an IC device including a support structure; a first elongated structure (e.g., a first nanoribbon) over the support structure, the first elongated structure extending in a first direction parallel to the support structure; a second elongated structure (e.g., a second nanoribbon) over the support structure and over the first elongated structure, the second elongated structure extending in the first direction; a first oxide layer over the first elongated structure, the first oxide layer having a first thickness that is substantially uniform across the first elongated structure; and a second oxide layer over the second elongated structure, the second oxide layer having a second thickness that is substantially uniform across the second elongated structure, where the first thickness is within 1% of the second thickness.

Example 2 provides the IC device of example 1, where a base of the first elongated structure is a first distance from an upper surface of the support structure, and a base of the second elongated structure is a second distance from the upper surface of the support structure, the second distance greater than the first distance.

Example 3 provides the IC device of example 1 or 2, further including a third elongated structure over the second elongated structure, the third elongated structure extending in the first direction, and the third elongated structure having a third oxide layer having a third thickness, where the third thickness is within 1% of the second thickness.

Example 4 provides the IC device of any of the preceding examples, where the first elongated structure includes silicon, and the second elongated structure includes silicon.

Example 5 provides the IC device of any of the preceding examples, where the first oxide layer includes silicon and oxygen, and the second oxide layer includes silicon and oxygen.

Example 6 provides the IC device of any of the preceding examples, where, in a cross-section through the first elongated structure and the second elongated structure, the cross-section perpendicular to the first direction, the first oxide layer encloses the first elongated structure and the second oxide layer encloses the second elongated structure.

Example 7 provides the IC device of any of the preceding examples, where the first thickness is a thickness of a portion of the first oxide layer over a top of the first elongated structure, and another portion of the first oxide layer under the first elongated structure has a third thickness, the third thickness within 1% of the first thickness.

Example 8 provides the IC device of any of examples 1-6, where the first thickness is a thickness of a portion of the first oxide layer over a top of the first elongated structure, and another portion of the first oxide layer at a side of the first elongated structure has a third thickness, the third thickness within 1% of the first thickness.

Example 9 provides a transistor device including a plurality of nanoribbons arranged in a stack, each nanoribbon in the stack each extending in a direction parallel to other nanoribbons in the stack; and an oxide layer formed around each of the plurality of nanoribbons, where the oxide layer around a nanoribbon has a thickness of less than 30 angstroms; where the transistor device has a breakdown voltage of at least 4 volts.

Example 10 provides the transistor device of example 9, where the transistor device has a drive current of between 20 and 80 microamps.

Example 11 provides the transistor device of example 9 or 10, where the oxide layer around a first of the plurality of nanoribbons and the oxide layer around a second of the plurality of nanoribbons have substantially the same uniformity.

Example 12 provides the transistor device of example 11, where the first of the plurality of nanoribbons is a lowermost nanoribbon in the stack, and the second of the plurality of nanoribbons is an uppermost nanoribbon in the stack.

Example 13 provides the transistor device of any of examples 9-12, where each of the plurality of nanoribbons in the stack includes silicon.

Example 14 provides the transistor device of any of examples 9-13, where the oxide layer around each of the plurality of nanoribbons includes silicon and oxygen.

Example 15 provides a method for forming an IC device including forming a stack of elongated semiconductor structures on a wafer; loading the wafer into a pressure chamber; increasing an internal temperature of the pressure chamber and increasing an internal pressure of the pressure chamber; forming an oxide layer around each of the stack of elongated semiconductor structures in the pressure chamber; removing the wafer from the pressure chamber; and forming a gate electrode around the oxide layer.

Example 16 provides the method of example 15, further including increasing an internal temperature of the pressure chamber to a maximum temperature between 300 and 550 degrees Celsius.

Example 17 provides the method of example 16, where the maximum temperature is between 400 and 500 degrees Celsius.

Example 18 provides the method of any of examples 15-17, where increasing the internal pressure of the pressure chamber includes adding water vapor into the pressure chamber, the water vapor increasing the internal pressure of the pressure chamber.

Example 19 provides the method of any of examples 15-18, where the oxide layer is formed at a substantially uniform thickness around each of the stack of elongated semiconductor structures.

Example 20 provides the method of any of examples 15-19, where the oxide layer around a lowermost one of the elongated semiconductor structures has a thickness within 1% of a thickness of the oxide layer around a topmost one of the elongated semiconductor structures.

Example 21 provides an IC package that includes an IC die, including one or more of the IC devices according to any one of the preceding examples. The IC package may also include a further component, coupled to the IC die.

Example 22 provides the IC package according to example 21, where the further component is one of a package substrate, a flexible substrate, or an interposer.

Example 23 provides the IC package according to examples 21 or 22, where the further component is coupled to the IC die via one or more first level interconnects.

Example 24 provides the IC package according to example 23, where the one or more first level interconnects include one or more solder bumps, solder posts, or bond wires.

Example 25 provides a computing device that includes a circuit board; and an IC die coupled to the circuit board, where the IC die includes one or more of the transistor/IC devices according to any one of the preceding examples (e.g., transistor/IC devices according to any one of examples 1-20), and/or the IC die is included in the IC package according to any one of the preceding examples (e.g., the IC package according to any one of examples 21-24).

Example 26 provides the computing device according to example 25, where the computing device is a wearable computing device (e.g., a smart watch) or hand-held computing device (e.g., a mobile phone).

Example 27 provides the computing device according to examples 25 or 26, where the computing device is a server processor.

Example 28 provides the computing device according to examples 25 or 26, where the computing device is a motherboard.

Example 29 provides the computing device according to any one of examples 25-28, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a support structure;
a first elongated structure over the support structure, the first elongated structure extending in a first direction parallel to the support structure;
a second elongated structure over the support structure and over the first elongated structure, the second elongated structure extending in the first direction;
a first oxide layer over the first elongated structure, the first oxide layer having a first thickness that is substantially uniform across the first elongated structure; and
a second oxide layer over the second elongated structure, the second oxide layer having a second thickness that is substantially uniform across the second elongated structure, wherein the first thickness is within 1% of the second thickness.

2. The IC device of claim 1, wherein a base of the first elongated structure is a first distance from an upper surface of the support structure, and a base of the second elongated structure is a second distance from the upper surface of the support structure, the second distance greater than the first distance.

3. The IC device of claim 1 or 2, further comprising a third elongated structure over the second elongated structure, the third elongated structure extending in the first direction, and the third elongated structure having a third oxide layer having a third thickness, wherein the third thickness is within 1% of the second thickness.

4. The IC device of any one of the preceding claims, wherein the first elongated structure comprises silicon, and the second elongated structure comprises silicon.

5. The IC device of any one of the preceding claims, wherein the first oxide layer comprises silicon and oxygen, and the second oxide layer comprises silicon and oxygen.

6. The IC device of any one of the preceding claims, wherein, in a cross-section through the first elongated structure and the second elongated structure, the cross-section perpendicular to the first direction, the first oxide layer encloses the first elongated structure and the second oxide layer encloses the second elongated structure.

7. The IC device of any one of the preceding claims, wherein the first thickness is a thickness of a portion of the first oxide layer over a top of the first elongated structure, and another portion of the first oxide layer under the first elongated structure has a third thickness, the third thickness within 1% of the first thickness.

8. The IC device of any one of claims 1-6, wherein the first thickness is a thickness of a portion of the first oxide layer over a top of the first elongated structure, and another portion of the first oxide layer at a side of the first elongated structure has a third thickness, the third thickness within 1% of the first thickness.

9. The IC device of any one of claims 1-8, wherein the first oxide layer has a thickness of less than 30 angstroms.

10. The IC device of any one of claims 1-9, the IC device comprising a transistor device that includes the first elongated structure and the second elongated structure, the transistor device having a breakdown voltage of at least 4 volts.

11. The IC device of claim 10, wherein the transistor has a drive current of between 20 and 80 microamps.

12. A method for forming an integrated circuit (IC) device comprising:
forming a stack of elongated semiconductor structures on a wafer;
loading the wafer into a pressure chamber;
forming an oxide layer around each of the stack of elongated semiconductor structures under high-pressure in the pressure chamber;
removing the wafer from the pressure chamber; and
forming a gate electrode around the oxide layer.

13. The method of claim 12, further comprising increasing an internal temperature of the pressure chamber to a maximum temperature between 300 and 550 degrees Celsius.

14. The method of claim 13, wherein the maximum temperature is between 400 and 500 degrees Celsius.

15. The method of any one of claims 12-14, further comprising forming a steam within the pressure chamber, the steam increasing a pressure in the pressure chamber.
